**Europäisches Patentamt**

**European Patent Office**

**Office européen des brevets**

(19)

(11) Numéro de publication: **0 030 876**
**B1**

(12) **FASCICULE DE BREVET EUROPEEN**

(45) Date de publication du fascicule du brevet: **23.11.83**

(51) Int. Cl.³: **G 01 R 33/032**

(21) Numéro de dépôt: **80401647.5**

(22) Date de dépôt: **17.11.80**

(54) Tête de mesure pour magnétomètre, et son utilisation dans un magnétomètre.

(30) Priorité: **14.12.79 FR 7930721**

(43) Date de publication de la demande:
**24.06.81 Bulletin 81/25**

(45) Mention de la délivrance du brevet:
**23.11.83 Bulletin 83/47**

(84) Etats contractants désignés:
**DE GB IT NL**

(56) Documents cités:
FR - A - 2 355 299
US - A - 3 756 690

APPLIED OPTICS, vol. 13, no. 5, (5-1974), pages
1001-1004, New York US J. WARNER:
"Excitation of hybrid modes in magnetooptic
waveguides"

(73) Titulaire: **THOMSON-CSF**
**173, Boulevard Haussmann**
**F-75379 Paris Cedex 08 (FR)**

(72) Inventeur: **Doriath, Gérard**
**THOMSON-CSF - SCPI 173, Bld Haussmann**
**F-75360 Paris Cedex 08 (FR)**
Inventeur: **Gaudry, Roger**
**THOMSON-CSF - SCPI 173, Bld Haussmann**
**F-75360 Paris Cedex 08 (FR)**
Inventeur: **Hepner, Georges**
**THOMSON-CSF - SCPI 173, Bld Haussmann**
**F-75360 Paris Cedex 08 (FR)**

(74) Mandataire: **Wang, Pierre et al,**
**THOMSON-CSF SCPI 173, Bld Haussmann**
**F-75379 Paris Cedex 08 (FR)**

Courier Press, Leamington Spa, England.

Tête de mesure pour magnétomètre, et son utilisation dans un magnétomètre

La présente invention se rapporte aux têtes de mesure pour magnétomètres qui permettent de mesurer un champ magnétique dans lequel la tête est plongée. Elle concerne également l'utilisation d'une telle tête dans les magnétomètres qui sont composés d'un boîtier de mesure de taille relativement importante relié par un câble à une tête de faible dimension pouvant mesurer le champ magnétique dans des espaces étroits et permettant de dresser. des cartes de gradient magnétique.

Dans le brevet FR—A—2 355 299 déposé le 18 Juin 1976 par la demanderesse sous le titre: "Appareil destiné à mesurer un champ magnétique", on a décrit un magnétomètre utilisant l'effet Faraday dans les couches minces de certains matériaux tels que les grenats d'yttrium et de fer couramment appelés YIG. Dans ce magnétomètre, on fait propager dans une couche mince d'une épaisseur de quelques microns un faisceau lumineux produit par un laser. Ce faisceau lumineux est propagé de manière guidée selon un mode unique, TM par exemple. Pour sélectionner ce mode, et compte tenu de la faible épaisseur de la couche, il faut faire entrer ce faisceau lumineux dans cette couche à l'aide d'un prisme de couplage. Sous l'effet du champ magnétique où est plongée la couche mince, le mode de propagation se convertit en mode TE avec un pourcentage plus ou moins grand selon la valeur du champ magnétique. Pour extraire le faisceau lumineux de la couche on utilise un prisme en matériau biréfringent qui délivre deux faisceaux lumineux séparés angulairement; l'un correspondant au mode TE, et l'autre au mode TM. L'intensité du faisceau correspondant au mode TE est une fonction de l'intensité du champ magnétique où est plongée la couche mince. Comme cette fonction n'est pas linéaire, on utilise pour effectuer la mesure une méthode de zéro qui consiste à compenser à l'intérieur de la couche mince le champ magnétique à mesurer par un champ antagoniste réglable produit par un bobinage. Pour détecter cette compensation, on superpose à ce champ continu un champ alternatif qui provoque l'apparition dans le faisceau correspondant au mode TE d'une modulation ne contenant, lorsque la compensation est réalisée, que des harmoniques pairs de la fréquence du champ alternatif dûs au fait que l'effet Faraday dépend de la valeur du champ magnétique et non pas de son sens. Lorsque la compensation n'est pas réalisée, on décèle l'apparition dans le faisceau modulé de composantes impaires, et notamment du fondamental, et on utilise ces composantes pour commander un servomécanisme qui règle le champ de compensation pour obtenir la disparition de ces composantes impaires.

Bien que la couche de mesure soit de faible dimension, les organes annexes nécessaires pour l'utiliser sont beaucoup plus grands et d'un réglage délicat. En effet, les prismes d'entrée et de sortie nécessaires pour obtenir un couplage du faisceau avec la couche et pour séparer angulairement les deux faisceaux en sortie sont d'assez grandes dimensions et la pression avec laquelle ils doivent être appuyés sur la couche doit être réglée d'une manière très critique à l'aide d'organes tels que des vis qui augmentent encore les dimensions de l'ensemble. Corrélativement les bobines qui doivent entourer cet ensemble sont de grande taille. De plus, la propagation monomode exige comme source lumineuse un laser de forte puissance et donc de grande taille. Enfin, la séparation angulaire des faisceaux provenant du prisme de sortie n'est pas très importante et nécessite que le détecteur soit placé suffisamment loin pour n'être excité que par le seul faisceau choisi.

Dans ces conditions, la tête de mesure rassemblant tous ces organes est beaucoup plus grande que ce que l'on aurait pu espérer compte tenu de la petite taille de la couche sensible.

Pour obtenir une tête de mesure de petite taille, l'invention propose une tête de mesure pour magnétomètre, du type comprenant des moyens permettant d'émettre un faisceau de lumière polarisé linéairement, une couche plane de matériau magnétique permettant de propager ce faisceau dans son plan, des moyens permettant d'induire dans la couche de matériau magnétique un champ magnétique parallèle au plan de cette couche et perpendiculaire à la direction de propagation du faisceau de lumière, de façon que la direction de polarisation dudit faisceau soit tourné si ladite couche est plongée dans un champ magnétique à mesurer, et des moyens permettant de mesurer cette rotation, caractérisée en ce que l'épaisseur de la couche de matériau magnétique permet une propagation guidée multimode du faisceau et, en coopération avec les moyens d'émission du faisceau et les moyens de mesure de la rotation, l'entrée et la sortie du faisceau par la tranche de la couche.

D'autres particularités et avantages de l'invention apparaîtront clairement dans la description suivante présentée à titre d'exemple non limitatif et faite en regard des figures annexées suivantes:

— la figure 1, qui représente une vue écorchée d'une tête de mesure selon l'invention;

— la figure 2, qui représente un schéma des organes électroniques raccordés à cette tête de mesure.

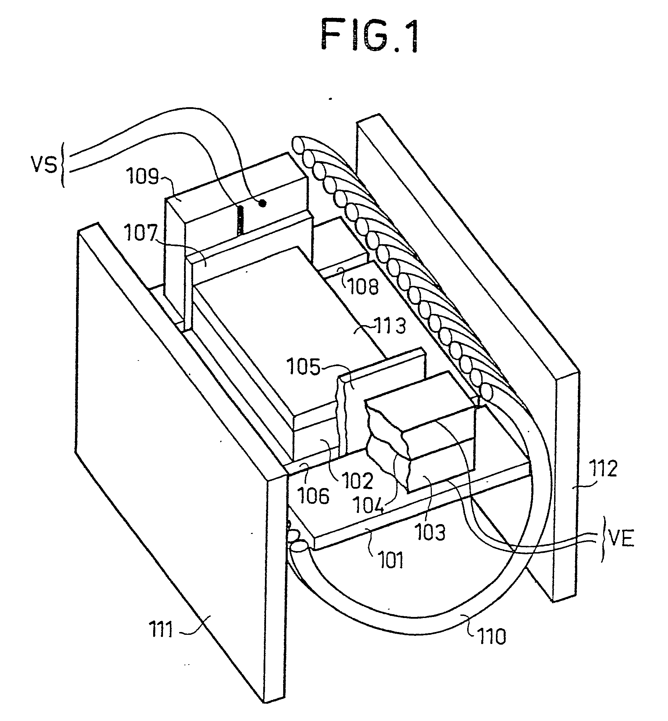

La tête de magnétomètre représentée en figure 1 comprend une plaquette en céramique 101 qui sert de support aux organes actifs de la tête. Sur cette plaquette, en son milieu, on a collé une plaquette plus petite 102 taillée dans un grenat de gadolinium et de gallium dit GGG dont les dimensions longueur par largeur et par épaisseur sont d'environ 10 x 3 x 0,7 mm. Sur la surface de GGG on a fait pousser par epitaxie une couche relativement épaisse de YIG substituée 113 répondant sensiblement à la composition $Y_{2,45}$ $Gd_{0,55}$ $Fe_{4,1}$ $O_{12}$. L'épaisseur obtenue peut être comprise entre 30 et 110 microns et une valeur typique est de 50 microns.

Une telle épaisseur de YIG permet de faire propager la lumière de manière guidée mais multimode, et dans ces conditions l'effet Faraday dû au champ magnétique se manifeste uniquement par une rotation du plan de polarisation de la lumière et non plus par une conversion du mode TM en mode TE. Ceci permet de coupler le faisceau lumineux par les faces terminales de la couche de YIG 113.

Néanmoins pour obtenir ce couplage il faut que ces surfaces d'entrée et de sortie soient les plus parfaites possibles. Il n'est généralement pas possible de trouver un axe de clivage en raison de l'inhomogénéité du matériau. On est alors amené à procéder à un polissage de ces faces. Pour cela, comme l'échantillon est très fin, on le noie dans un support en le fixant à ce support avec par exemple une couche de cire. On peut ainsi polir l'ensemble du support et de la face de sortie sans provoquer de fractures. Toutefois, on observe au niveau de l'interface entre la surface supérieure du YIG et la cire qui le maintient dans le support une zone perturbée dont l'épaisseur ne dépase pas 10 microns et dont on a pu vérifier qu'elle est sans influence sur le couplage avec la source de lumière et le détecteur pour les épaisseurs citées ci-dessus.

Le protocole de polissage est par exemple le suivant:

— tout d'abord, un douci à l'émeri avec successivement un grain de 22,5; 12,5; 9,5 microns;

— ensuite, un polissage sur un tissu imprégné d'un mélange d'oxalate ferreux et d'alumine;

— un polissage physico-chimique terminal.

La source lumineuse est formée d'une diode laser 103 fixée sur la plaquette 101 de telle manière que sa jonction par la tranche 104 de laquelle sort le faisceau lumineux de lumière cohérente soit située sensiblement au centre de la couche de YIG. La surface émissive d'une telle diode ayant sensiblement une épaisseur de 0,2 micron et une largeur de 15 microns, ce positionnement est relativement aisé en jouant par exemple sur la couche de colle qui maintient la diode laser sur la plaquette 101 ou au besoin en rajoutant une cale entre la diode et la plaquette. Cette diode est alimentée avec une tension électrique VE convenable par l'intermédiaire de deux connexions d'entrée.

Entre la diode laser et le substrat portant la couche de YIG, on a placé un polariseur 105 qui permet de polariser linéairement la lumière émise par la diode laser dans la couche de YIG. Ce polariseur est par exemple découpé dans un film polarisant d'un type couramment utilisé en optique. Son épaisseur est telle qu'il ne perturbe pas le couplage entre la diode émettrice et la couche YIG pourvu qu'on prenne bien soin de pincer modérément le polariseur entre la diode et la plaquette 102. Une rainure 106 pratiquée dans la plaquette 101 permet de faciliter le montage du polariseur en immobilisant celui-ci, par exemple par une goutte de colle, avant de positionner la plaquette 102 et la diode 103.

A l'autre extrémité de la plaquette 102, on a placé un analyseur 107 semblable au polariseur 105 mais croisé par rapport à lui et immobilisé pour le montage dans une autre fente 108.

Cet analyseur est légèrement pincé entre la plaquette 102 et une photodiode détectrice 109. Cette photodiode est par exemple du type au germanium soumise à une polarisation inverse d'une dizaine de volts et sa surface active est réalisée sous la forme sensiblement d'un rectangle pour capter le maximum de lumière en sortie de la couche YIG. Elle émet dans ces conditions un signal VS.

La plaquette 101 et l'ensemble des éléments actif qu'elle supporte sont placés à l'intérieur d'un solénoïde 110 qui permet d'appliquer le champ magnétique de compensation et le champ alternatif de mesure.

Pour que l'effet de rotation Faraday se manifeste dans la couche YIG il est nécessaire que l'aimantation initiale de cette couche soit transverse par rapport à la direction de la lumière dans celle-ci. Pour cela il est nécessaire d'utiliser des moyens qui induisent ce champ transverse avec une valeur d'environ 1 Oersted. Ces moyens sont par exemple des aimants permanents représentés sur la figure sous la forme des blocs 111 et 112. On peut également utiliser si on veut optimiser la valeur de ce champ selon la sensibilité à obtenir des bobines de Helmoltz placées à la place de ces aimants 111 et 112.

La figure montre clairement que les dimensions hors tout de la tête de mesure obtenue sont de l'ordre de la plus grande dimension de la plaquette 101, c'est-à-dire d'environ 1 cm.

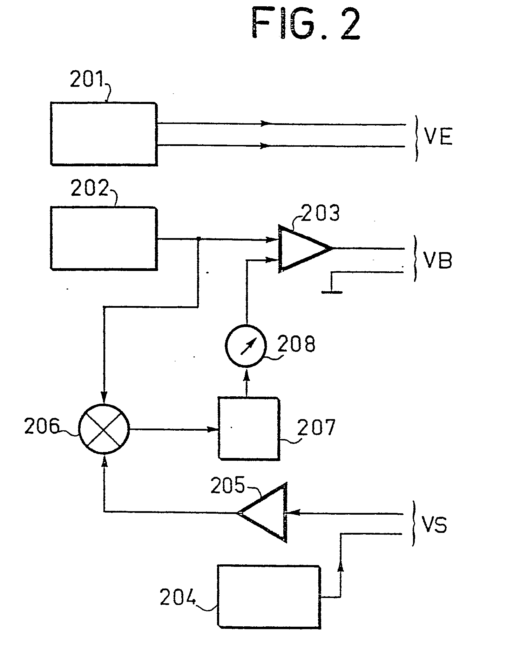

La tête de mesure représentée sur la figure 1 est reliée par un câble multiconducteurs au boîtier de mesure dont le schéma simplifié est représenté sur la figure 2.

Ce boîtier comprend tout d'abord une source d'alimentation stabilisée 201 qui fournit le courant nécessaire à l'alimentation de la diode laser 103. Pour une diode laser émettant dans l'infrarouge sous une longueur d'onde de 1,3 micron, une puissance lumineuse de 4 milliwatts est obtenue avec une intensité de 200 milliampères. Une telle puissance lumineuse à cette longueur d'onde permet parfaitement de faire fonctionner le dispositif avec la sensibilité désirée.

Un oscillateur 202 fournit un signal à fréquence relativement élevée, 100 kHz par exemple. Ce signal est additionné à un signal continu ou faiblement variable dans un amplificateur 203 qui délivre une tension VB appliquée au solénoïde 110.

Un générateur de tension de polarisation 204 permet de délivrer la tension de polarisation de la diode 109 qui, en détectant la faisceau lumineux, délivre le signal VS. Ce signal VS est amplifié dans un amplificateur sélectif 205 centré sur la fréquence du signal fourni par l'oscillateur 202.

Le signal en sortie de cet amplificateur 205 est comparé avec le signal en sortie de l'oscillateur 202 dans un détecteur synchrone 206 qui mesure à la fois l'amplitude du signal à la fréquence fondamentale et son changement de phase lors du passage par zéro de cette amplitude. Ce détecteur délivre un signal d'erreur.

Ce signal d'erreur est appliqué à un servomécanisme 207 qui comprend par exemple un générateur de tension et un filtre correcteur qui permettent de générer une tension de contre-réaction qui, appliquée par l'intermédiaire de l'amplificateur 203 au solénoïde 110, tend à annuler le signal d'erreur en sortie du comparateur 206 en compensant le champ magnétique à mesurer dans l'intérieur de la couche YIG 113.

Pour obtenir la valeur du champ magnétique à mesurer, on mesure la valeur du champ magnétique de compensation par l'intermédiaire de la valeur du signal qui le génère et qui est appliqué par le servomécanisme 207 à l'amplificateur 203. Pour cela un appareil de mesure 208 est inséré entre le servomécanisme 207 et l'amplificateur 203.

Dans ces conditions, et pour les valeurs numériques citées plus haut, la tête de mesure, dont le volume est de l'ordre du centimètre cube, a une sensibilité d'environ $10^{-7}$ Oersted pour un champ magnétique pouvant évoluer dans une gamme de fréquences allant du continu à 1000 Hertz.

## Revendications

1. Tête de mesure pour magnétomètre, du type comprenant des moyens (103, 105) permettant d'émettre un faisceau de lumière polarisé linéairement, une couche plane de matériau magnétique (113) permettant de propager ce faisceau dans son plan, des moyens (111, 112) permettant d'induire dans la couche de matériau magnétique (113) un champ magnétique parallèle au plan de cette couche et perpendiculaire à la direction de propagation du faisceau de lumière, de façon que la direction polarisation dudit faisceau soit tourné si ladite couche est plongée dans un champ magnétique à mesurer, et des moyens (107—110) permettant de mesurer cette rotation, caractérisée en ce que l'épaisseur de la couche de matériau magnétique (113) permet une propagation guidée multimode du faisceau et, en coopération avec les moyens d'emission (103, 105) du faisceau et les moyens de mesure (107, 110) de la rotation, l'entrée et la sortie du faisceau par la tranche de la couche (113).

2. Tête selon la revendication 1, caractérisée en ce que la couche de matériau magnétique (113) est supportée par un substrat (102), que les moyens d'émission du faisceau de lumière polarisée comprennent une diode émettrice (103) de lumière et un polariseur (105), et que les moyens de mesure comprennent un analyseur (107) croisé par rapport au polariseur (105) et un photodétecteur (109).

3. Tête selon la revendication 2, caractérisée en ce qu'elle comprend en outre une plaquette (101) permettant de supporter le substrat (102), la diode émettrice (103), le polariseur (105), l'analyseur (107), et le photodétecteur (109), de manière à faire coïncider les zones actives (104) de la diode émettrice (103) et du photodétecteur (109) avec la tranche de la couche de matériau magnétique, et à pincer le polariseur entre la diode émettrice et le substrat et l'analyseur entre le photodétecteur et le substrat.

4. Tête selon la revendication 3, caractérisé en ce que la diode émettrice (103) est une diode laser, et que le polariseur (105) et l'analyseur (107) sont des films polarisants.

5. Tête selon l'une quelconque des revendications 1 à 4, caractérisée en ce que les moyens de mesure de la rotation comprennent en outre un bobinage (110) permettant d'induire dans la couche de matériau magnétique un champ magnétique parallèle au plan de cette couche et antagoniste du champ à mesurer.

6. Tête selon l'une quelconque des revendications 1 à 5, caractérisée en ce que le matériau magnétique est un grenat d'yttrium et de fer épitaxié sur un grenat de gadolinium et de gallium avec une épaisseur comprise entre 30 microns et 110 microns.

7. Tête selon l'une quelconque des revendications 1 à 6, caractérisée en ce que la longueur d'onde de la lumière polarisée est sensiblement de 1,3 micron.

8. Utilisation de la tête de mesure selon la revendication 5 dans un magnétomètre comprenant:

— des moyens (202, 203, 207) permettant d'alimenter le bobinage de la tête de mesure en courant continu produisant le champ magnétique antagoniste et en courant alternatif générant un champ magnétique alternatif superposé au champ antagoniste, et

— des moyens (205, 206) permettant de régler le courant continu d'une telle manière que le champ antagoniste ait la même valeur que le champ à mesurer, ledit réglage s'effectuant en décelant la disparition des harmoniques impaires de la fréquence du champ alternatif dans les variations de la rotation de la polarisation du faisceau lumineux.

## Patentansprüche

1. Meßkopf für ein Magnetfeldmeßgerät, der Mittel (103, 105), mit denen ein linear polarisierter Lichtstrahl ausgesandt werden kann, eine ebene Schicht aus Magnetmaterial (113), in deren Ebene sich dieser Strahl fortpflanzen kann, Mittel (111, 112), mit denen in die Schicht aus magnetischem Material (113) ein zur Ebene dieser Schicht paralleles und zur Fortpflanzungsrichtung des Lichtstrahls senkrechtes Magnetfeld eingebracht werden kann, so daß die Polarisationsrichtung des Strahls sich dreht, wenn die Schicht einem zu messenden Magnetfeld ausgesetzt ist, und Mittel (107—110) aufweist, mit denen diese Drehung gemessen werden kann, dadurch gekennzeichnet, daß die Dicke der Schicht aus magnetischem Material (113) eine in Multimode geführte Fortpflanzung des Strahls sowie in Zusammenwirken mit den Strahlsendemitteln (103, 105) und den Mitteln (107, 110) zur Messung der Drehung die Einführung und den Austritt des Strahls über die Schnittkante der Schicht (113) erlaubt.

2. Kopf nach Anspruch 1, dadurch gekennzeichnet, daß die Schicht aus magnetischem Material (113) auf ein Substrat (102) aufgebracht ist, daß die Mittel zum Aussenden des polarisierten Lichtstrahls eine Licht emittierende Diode (103) und einen Polarisator (105) umfassen und daß die Meßmittel einen Analysator (107), der bezüglich des Polarisators in Querlage ausgerichtet ist, und einen Photodetektor (109) enthalten.

3. Kopf nach Anspruch 2, dadurch gekennzeichnet, daß er außerdem ein Plättchen (101) aufweist, das das Substrat (102), die emittierende Diode (103), den Polarisator (105), den Analysator (107) und den Photodetektor (109) tragen kann, so daß die aktiven Zonen (104) der emittierenden Diode (103) und des Photodetektors (109) mit der Schnittkante der Schicht aus magnetischem Material koinzidieren und der Polarisator zwischen der emittierenden Diode und dem Substrat sowie der Analysator zwischen dem Photodetektor und dem Substrat eingespannt wird.

4. Kopf nach Anspruch 3, dadurch gekennzeichnet, daß die emittierende Diode (103) eine Laserdiode ist und daß der Polarisator (105) und der Analysator (107) als polarisierende Filme ausgebildet sind.

5. Kopf nach einem beliebigen der Ansprüche 1 bis 4, dadurch gekennzeichnet, daß die Meßmittel für die Drehung außerdem eine Spule (110) aufweisen, mit der in die Schicht aus magnetischem Material ein zur Schichtebene paralleles und dem zu messenden Magnetfeld entgegengerichtetes Magnetfeld induziert werden kann.

6. Kopf nach einem beliebigen der Ansprüche 1 bis 5, dadurch gekennzeichnet, daß das magnetische Material ein Yttrium-Eisen-Granat ist, das auf ein Gadolinium-Gallium-Granat epitaxial aufgebracht ist, mit einer Schichtdicke zwischen 30 und 110 $\mu$m.

7. Kopf nach einem beliebigen der Ansprüche 1 bis 6, dadurch gekennzeichnet, daß die Wellenlänge des Lichts bei 1,3 $\mu$m liegt.

8. Verwendung des Meßkopfs nach Anspruch 5 in einem Magnetfeldmeßgerät, das enthält:
—Mittel (202, 203, 207), mit denen die Spule des Meßkopfes mit Gleichstrom, durch den das entgegengerichtete Magnetfeld erzeugt wird, und mit Wechselstrom gespeist werden kann, mit dem ein Wechselfeld erzeugt wird, das sich dem entgegengerichteten Magnetfeld überlagert, und
—Mittel (205, 206) zur Regelung des Gleichstroms, derart, daß das entgegengerichtete Magnetfeld denselben Wert wie das zu messende Feld besitzt, wobei die Regelung so erfolgt, daß das Verschwinden der ungeradzahligen Harmonischen der Frequenz des Wechselfelds in den Änderungen der Drehung der Polarisation des Lichtstrahls entdeckt wird.

## Claims

1. A measuring head of a magnetometer device comprising means (103, 105) ensuring the emission of a linearly polarized light beam, an even layer of magnetic material (113) which allows the propagation of that beam in its plane, means (111, 112) permitting the induction, into the layer of magnetic material (113), of a magnetic field which is parallel to the plane of said layer and perpendicular to the propagation direction of the light beam in such a way that the polarisation direction of said beam is turned if said layer is inserted into a magnetic field which is to be measured, and means (107—110) by which this rotation can be measured, characterized in that the thickness of the layer of magnetic material (113) allows a guided multimode propagation of the beam, and in cooperation with the means (103, 105) for emitting the beam and the rotation measuring means (107, 110) the input and the output of the beam by the cut surface of the layer (113).

2. A head according to claim 1, characterized in that the layer of magnetic material (113) is supported by a substrate (102), that the means for the emission of the polarized light beam comprise a light emission diode (103) and a polarizer (105), and that the measuring means comprise an analyzer (107) which is crossoriented with respect to the polarizer (105) and a photodetector (109).

3. A head according to claim 2, characterized in that it further comprises a plate (101) which supports the substrate (102), the emission diode (103), the polarizer (105), the analyzer (107) and the photodetector (109) in such a way that the active zones (104) of the emission diode (103) and of the photodetector (109) coincide with the cut surface of the magnetic material, and that the polarizer is held between the emission diode and the substrate and the analyzer is held between the photodetector and the substrate.

4. A head according to claim 3, characterized in that the emission diode (103) is a laser diode and that the polarizer (105) and the analyzer (107) are polarizing films.

5. A head according to any one of the claims 1 to 4, characterized in that the rotation measuring means further comprise a coil (110) by which a magnetic field which is parallel to the plane of said layer and opposed to the field to be measured can be induced into the layer of magnetic material.

6. A head according to any one of the claims 1 to 5, characterized in that the magnetic material is an yttrium-iron-granat which is epitaxiated on a gadolinium-gallium-granat, the thickness being between 30 and 110 $\mu$m.

7. A head according to any one of the claims 1 to 6, characterized in that the wave length of the polarized light is about 1,3 $\mu$m.

8. The use of the measuring head according to claim 5 in a magnetometer device comprising:

—means (202, 203, 207) allowing to feed to the measuring head coil a constant current which produces the opposed magnetic field, and an alternating current which produces an alternating magnetic field which is superposed to the opposed field,

—and means (205, 206) by which the constant current can be adjusted in such a way that the opposed field has the same value as the field which is to be measured, the adjusting being made by detecting the disappearance of the odd harmonics of the frequency of the alternating field in the variations of rotation of the polarization in the light beam.

# FIG.1

# FIG. 2